**Europäisches Patentamt**

**European Patent Office**

**Office européen des brevets**

(19)

(11) Veröffentlichungsnummer: **0 018 570
B1**

(12)

# EUROPÄISCHE PATENTSCHRIFT

(45) Veröffentlichungstag der Patentschrift:
13.04.83

(21) Anmeldenummer: 80102136.1

(22) Anmeldetag: **21.04.80**

(51) Int. Cl.³: **H 04 B 1/12,** H 03 G 3/30,
G 01 R 15/07

(54) **Schaltungsanordnung zur Unterdrückung von Störsignalen.**

(30) Priorität: **27.04.79 DD 212529**

(43) Veröffentlichungstag der Anmeldung:
**12.11.80 Patentblatt 80/23**

(45) Bekanntmachung des Hinweises auf die Patenterteilung:
**13.04.83 Patentblatt 83/15**

(84) Benannte Vertragsstaaten:
**AT CH DE FR GB LI**

(56) Entgegenhaltungen:
**CH-A-559 472
DD-A-91 092
DE-B-1 118 261
FR-A-2 088 601
NL-A-6 513 747
US-A-3 581 222**

(73) Patentinhaber: **VEB Transformatoren- und Röntgenwerk
"Hermann Matern", Overbeckstrasse 48,
DDR-8030 Dresden (DD)**

(72) Erfinder: **Lemke, Eberhard, Dr.sc.techn.,
Herbert-Bochow-Strasse 4, DDR-801 Dresden (DD)**

(74) Vertreter: **Patentanwälte Beetz sen. - Beetz jun. Timpe -
Siegfried - Schmitt-Fumian, Steinsdorfstrasse 10,
D-8000 München 22 (DE)**

Schaltungsanordnung zur Unterdrückung von Störsignalen

Die Erfindung bezieht sich auf eine Schaltungsanordnung zur Unterdrückung von Störsignalen aus einem Signalgemisch, das Teilentladungsimpulse (TE-Impulse) und Störsignale enthält, die im Vergleich zu den TE-Impulsen eine lange Dauer aufweisen. Sie dient z. B. zur Beseitigung von Störungen durch Rundfunksendeanlagen.

Empfindliche Teilentladungsmessungen (TE-Messungen) werden häufig durch von Sendeanlagen herrührende HF-Signale gestört. Zur Unterdrückung derartiger HF-Störsignale sind aufwendige Maßnahmen erforderlich, die einerseits das Ziel haben, durch geeignete Abschirmungen ein Eindringen der Störsignale von der Umgebung in den Hochspannungsprüfkreis zu vermeiden und außerdem durch schaltungstechnische Lösungen den noch vorhandenen Grundstörpegel vom Meßsignal fernzuhalten.

Aus der DD-PS 91 092 ist eine Schaltung zur Unterdrückung von Hochfrequenzstörsignalen bekannt, die darauf beruht, daß das dem TE-Signal überlagerte störende HF-Signal gleichgerichtet wird, so daß es einen nachgeschalteten Hochpaß nicht durchläuft und somit eliminiert wird. Die TE-Impulse führen dagegen zu einer kurzzeitigen Verlagerung des Bezugspegels, so daß dieses Signal durch den nachfolgenden Hochpaß übertragen wird und somit bewertet werden kann. Obwohl durch diese Schaltung das Verhältnis von Nutz- zu Störsignal verbessert wird, besitzt sie den Nachteil, daß durch den Hochpaß eine starke Abhängigkeit der Amplitude des Ausgangsimpulses von der Form des Eingangsimpulses auftritt, so daß bei Änderung der Form der TE-Impulse beachtliche Meßfehler in Kauf genommen werden müssen. Hierzu kommt noch, daß infolge der nichtlinearen Diodenkennlinie ein erheblicher Linearitätsfehler, insbesondere bei kleinen Aussteuerungen, auftritt.

Zur Rauschunterdrückung und damit zur Verbesserung des Empfangs elektromagnetischer Signale ist es auch bekannt, einen Verstärker mittels dieses Störsignals zu steuern (FR-PS 2 088 601). Bei dieser Schaltung wird ein Schwellwertverstärker angewandt, bei dem eine Änderung der Verstärkungscharakteristik erfolgt, indem seine Ansprechschwelle vom Rauschen gesteuert wird, so daß das Nutzsignal abgetrennt wird. Wenn ein Nutzsignal vorliegt, dessen Pegel größer als der des Störsignals ist, erfolgt dessen Weiterverarbeitung.

Bei der TE-Messung tritt andererseits das Nutzsignal, dessen Amplitude kleiner als die des Störsignals sein kann, stochastisch auf und ist dem Störsignal additiv überlagert. Tritt die Überlagerung des Störsignals mit dem Teilentladungssignal so auf, daß im Signalgemisch eine höhere Amplitude auftritt, so erfolgt die Erfassung der Amplitudenerhöhung.

Die Aufgabe der Erfindung besteht mithin in der Angabe einer Schaltung zur Unterdrückung von HF-Störungen aus einem Signalgemisch mit TE-Impulsen als Nutzsignalen, dessen Ladungsinhalt bestimmt werden soll, wobei die Schaltung eine höhere Empfindlichkeit aufweisen soll und der Einfluß der Impulsform auf das Ausgangssignal der Schaltung verringert und zugleich die Proportionalität zwischen Ein- und Ausgangssignal auch bei kleinen Aussteuerungen verbessert sein soll.

Die Aufgabe wird anspruchsgemäß gelöst.

Die erfindungsgemäße Schaltung zur Unterdrückung von Störsignalen aus einem Signalgemisch, das Teilentladungsimpulse und Störsignale enthält, die im Vergleich zu den Teilentladungsimpulsen eine lange Dauer aufweisen, und dessen Amplitude beim Auftreten der Teilentladungsimpulse die Scheitelwerte der Störsignale überschreitet, z. B. zur Beseitigung von Störungen von Rundfunksendeanlagen, bei der aus dem Signalgemisch nach der Zuführung zu einem Verstärker der Störsignalanteil eliminiert und die Teilentladungsimpulse mittels eines schwellwertabhängigen Verstärkers gewonnen werden, ist gekennzeichnet durch

(A) einen Vorverstärker mit einem bipolaren Ausgang, an dem das Signalgemisch in bipolarer Form vorliegt, sowie einem unipolaren Ausgang, an dem das Signalgemisch in unipolarer Form vorliegt,

(B) einen als Integrierverstärker ausgebildeten schwellwertabhängigen Verstärker, der mit dem bipolaren Ausgang des Vorverstärkers verbunden ist,

(C) mindestens einen Bandpaß, der mit dem unipolaren Ausgang des Vorverstärkers verbunden ist und dessen Durchlaßbereich dem Frequenzspektrum der Störsignale entspricht, und

(D) einer mit dem Ausgang des Bandpasses verbundenen Gleichrichterschaltung, die als Spitzenwertgleichrichter arbeitet und deren Ausgangsspannung bzw. eine ihr proportionale Spannung als Regelspannung am Integrierverstärker liegt.

Die Gleichrichterschaltung eliminiert nach der Vorverstärkung den Störsignalanteil und leitet die Teilentladungsimpulse zum Integrierverstärker weiter, für dessen Regelspannung die Ausgangsspannung der Gleichrichterschaltung oder eine ihr proportionale Spannung dient.

Der Integrierverstärker weist vorteilhafterweise einen Doppeltransistor auf, wodurch bei entsprechender Beschaltung die Verarbeitung positiver wie auch negativer Impulse möglich ist.

Durch die Einschaltung einer Pegelanpassungsstufe zwischen den Ausgang der Gleichrichterschaltung und die Emitteranschlüsse des Doppeltransistors ist die Regelung des Aussteuerbereichs des Integrierverstärkers in der Weise möglich, daß nur der Anteil des Meßsignals weiterverarbeitet wird, dessen Amplitude den Scheitelwert des HF-Störsignals überschreitet.

Die durch die Erfindung erreichten Vorteile bestehen darin, daß der Einfluß der Impulsform auf das Ausgangssignal der Entstörschaltung verringert wird, wobei gleichzeitig die Proportionalität zwischen Ein- und Ausgangssignal auch bei kleinen Aussteuerungen verbessert wird.

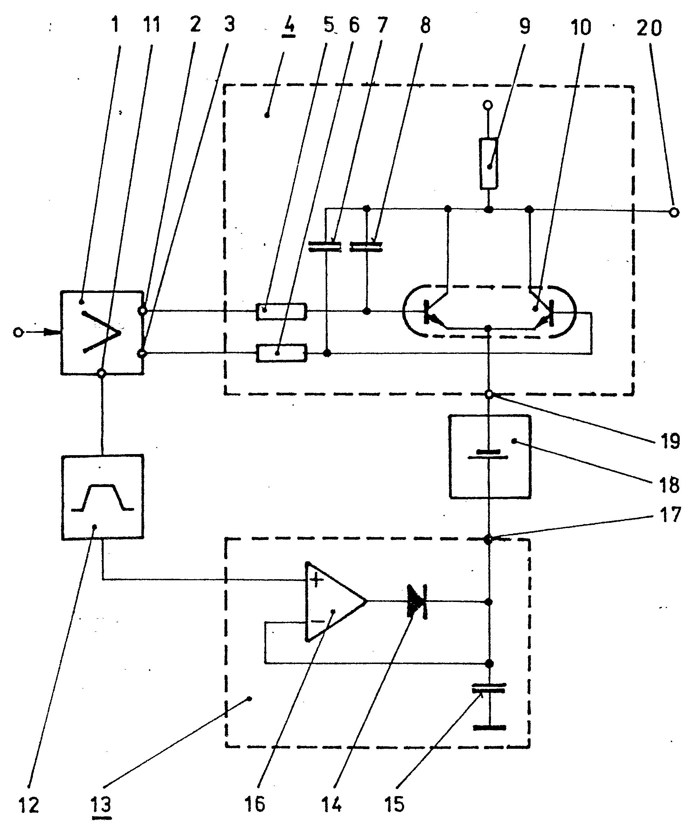

Im folgenden wird die Erfindung anhand der Zeichnung näher erläutert, in der eine Ausführungsform der erfindungsgemäßen Schaltung als Prinzipschaltung zur Unterdrückung von HF-Störsignalen für die TE-Messung dargestellt ist.

Der Vorverstärker 1, der das TE-Signal liefert, aus dem die Impulsladung als TE-Kenngröße ermittelt werden soll, ist so ausgeführt, daß an den Ausgangsanschlüssen 2 und 3 die TE-Impulse bipolar zur Verfügung stehen. Diese werden einem symmetrisch aufgebauten Integrierverstärker 4 zugeführt. Der Integrierverstärker 4 enthält in jedem Steuerweg einen Widerstand 5 bzw. 6 zur Aufladung sowie Kondensatoren 7 bzw. 8 zur Integration, einen Meßwertwiderstand 9 und als aktives Bauelement einen Doppeltransistor 10. Die Basis-Emitter-Spannung des Doppeltransistors 10 wird im Ruhezustand, d. h. ohne Vorliegen eines HF-Störsignals, so eingestellt, daß der Kollektorstrom sehr klein ist und nur einen vernachlässigbar kleinen Spannungsabfall am Meßwiderstand 9 verursacht.

Dem Verstärker 1 wird außerdem das dem TE-Signal überlagerte HF-Störsignal am unipolaren Ausgangsanschluß 11 entnommen und über einen Bandpaß 12, der dem Frequenzspektrum des HF-Störsignals angepaßt ist, einer als Spitzenwertgleichrichter arbeitenden Gleichrichterschaltung 13 zugeführt, der als wesentliche Elemente eine Gleichrichterdiode 14, einen Ladekondensator 15 sowie einen Operationsverstärker 16 zur Linearisierung der Kennlinie der Gleichrichterdiode 14 enthält. Die am Ausgangsanschluß 17 der Gleichrichterschaltung 13 anliegende Regelspannung wird zur Potentialanpassung einer Pegelanpassungsstufe 18 zugeführt und gelangt dann an den emitterseitigen Anschluß 19 des Doppeltransistors 10. Dadurch wird erreicht, daß sich beim Auftreten eines HF-Störsignals als die Basis-Emitter-Spannung stets in der Weise ändert, daß der Integrierverstärker 4 immer nur dann ausgesteuert wird, wenn die Amplitude des Meßsignals den Scheitelwert des HF-Signals übersteigt.

Am Ausgangsanschluß 20 des Integrierverstärkers 4 erscheint daher kein HF-Störsignal, sondern es werden nur die TE-Impulse bewertet, die über den Pegel des HF-Störsignals hinausragen. Obwohl der Integrierverstärker 4 durch die Arbeitspunkteinstellung nur eine unipolare Aussteuerung zuläßt, wird durch die bipolare Ansteuerung über die beiden Basisanschlüsse vom Vorverstärker 1 her dennoch gewährleistet, daß beide Polaritäten der TE-Impulse bewertet werden.

**Patentansprüche**

1. Schaltungsanordnung zur Unterdrückung von Störsignalen aus einem Signalgemisch, das Teilentladungsimpulse und Störsignale enthält, die im Vergleich zu den Teilentladungsimpulsen eine lange Dauer aufweisen, und dessen Amplitude beim Auftreten der Teilentladungsimpulse die Scheitelwerte der Störsignale überschreitet, z. B. zur Beseitigung von Störungen durch Rundfunksenderanlagen, bei der aus dem Signalgemisch nach der Zuführung zu einem Verstärker (1) der Störsignalanteil eliminiert wird und die Teilentladungsimpulse mittels eines schwellwertabhängigen Verstärkers (10) gewonnen werden, gekennzeichnet durch

(A) einen Vorverstärker (1) mit einem bipolaren Ausgang (2, 3), an dem das Signalgemisch in bipolarer Form vorliegt, sowie einem unipolaren Ausgang (11), an dem das Signalgemisch in unipolarer Form vorliegt,

(B) einen als Integrierverstärker (4) ausgebildeten schwellwertabhängigen Verstärker, der mit dem bipolaren Ausgang des Vorverstärkers (1) verbunden ist,

(C) mindestens einen Bandpaß (12), der mit dem unipolaren Ausgang des Vorverstärkers (1) verbunden ist und dessen Durchlaßbereich dem Frequenzspektrum der Störsignale entspricht, und

(D) einer mit dem Ausgang des Bandpasses (12) verbundenen Gleichrichterschaltung (13), die als Spitzenwertgleichrichter arbeitet und deren Ausgangsspannung bzw. eine ihr proportionale Spannung als Regelspannung am Integrierverstärker (4) liegt.

2. Schaltung nach Anspruch 1, dadurch gekennzeichnet, daß der Integrierverstärker (4) als aktives Bauelement einen Doppeltransistor (10) enthält, dessen Basisanschlüsse über ein Integriernetzwerk aus Widerständen (5; 6) und Kondensatoren (7; 8) mit je einem Anschluß des bipolaren Ausgangs des Vorverstärkers (1), dessen Kollektoren gemeinsam über einen Meßwiderstand (9) mit der Betriebsspannungsquelle und dessen Emitteranschlüsse gemeinsam über eine Pegelanpassungsstufe (18) mit dem Ausgangsanschluß (17) der Gleichrichterschaltung (13) verbunden sind.

**Claims**

1. Circuit for suppressing interference signals from a composite signal which contains partial discharge pulses and interference signals having a long duration as compared to said partial discharge pulses, the amplitude of said composite signal exceeding the peak values of the interference signals upon the occurrence of said partial discharge pulses, for instance to remove noise caused by broadcasting systems, wherein the interference signal component is eliminated from said composite signal after delivery thereof to an amplifier (1), and the partial discharge pulses are obtained by means of a threshold-responsive amplifier (10), characterized by

A) a preamplifier (1) having a bipolar output terminal (2, 3) to which said composite signal is applied in bipolar form, and having a unipolar output terminal (11) to which said composite signal is applied in unipolar form,
a threshold-responsive amplifier designed as an integrating amplifier (4), which is connected to the bipolar output terminal of said preamplifier (1),

B) at least one band-pass filter (12) connected to the unipolar output terminal of said preamplifier (1) and having a pass band corresponding to the frequency spectrum of the interference signals, and

C) a rectifying circuit (13) connected to the output of said band pass filter (12) and operating as peak value rectifier, the output voltage of said rectifying circuit or, respectively, a voltage proportional thereto being applied as control voltage to the integrating amplifier (4).

2. Circuit according to claim 1, characterized in that the integrating amplifier (4) contains as active element a tetrajunction transistor (10) whose base terminals are connected via an integrating network consisting of resistors (5; 6) and capacitors (7; 8) to a respective terminal of the bipolar output of the preamplifier (1), and whose collectors are connected in common via a precision resistor (9) to the operating voltage supply, and whose emitter terminals are connected in common via a level matching circuit (18) to the output terminal (17) of the rectifying circuit (13).

## Revendications

1. Dispositif de circuit pour éliminer les signaux parasites dans un mélange de signaux contenant des impulsions de décharge partielle et des signaux parasites, lesquels par comparaison avec les impulsions de décharge partielle, comportent une durée plus longue, et dont l'amplitude lors de l'intervention des impulsions de décharge partielle, dépasse la valeur de pointe des signaux parasites, dispositif permettant par exemple d'éviter des perturbations dûes à des installations radio-émettrices, dispositifs dans lequel la fraction correspondante aux signaux parasites est éliminée du mélange de signaux après l'application de celui-ci à un amplificateur (1), tandis que les impulsions de décharge partielle, sont extraites au moyen d'un amplificateur (10) commandé en fonction d'une valeur de seuil, dispositif caractérisé en ce qu'il comporte:

A — un préamplificateur (1) avec une sortie bipolaire (2, 3), à laquelle le mélange de signaux apparait sous forme bipolaire, ainsi qu'une sortie unipolaire (11), à laquelle le mélange de signaux apparait sous forme unipolaire,

B — un amplificateur commandé en fonction d'une valeur de seuil et revêtant la forme d'un amplificateur intégrateur (4), qui est relié à la sortie bipolaire du préamplificateur (1),

C — au moins un filtre passe-bande (12), relié à la sortie unipolaire du pré-amplificateur (1), et dont la bande passante correspond au spectre de fréquences des signaux parasites.

D — Un ensemble redresseur (13) relié à la sortie du filtre passe-bande (12) et qui assure le redressement des valeurs de pointes, tandis que sa tension de sortie, ou bien une tension proportionnelle à celle-ci, est appliquée comme tension de réglage à l'amplificateur intégrateur (4).

2. Dispositif de circuit selon la revendication 1, caractérisé en ce que l'amplificateur intégrateur (4) comporte comme composants actifs, un transistor double (10), dont les raccordements de base sont respectivement reliés par l'intermédiaire d'un réseau intégrateur constitué de résistances (5, 6) et de condensateurs (7, 8) avec l'un des raccordements de la sortie bipolaire du pré-amplificateur (1), dont les collecteurs sont reliés en commun par l'intermédiaire d'une résistance de mesure (9) avec la source de tension de fonctionnement, et dont les raccordements d'émetteurs sont reliés en commun par l'intermédiaire d'un étage d'adaptation de niveau (18) au raccordement de sortie (17) de l'ensemble redresseur (13).